(19) **Europäisches Patentamt / European Patent Office / Office européen des brevets**

(11) **EP 3 248 285 B1**

(12) **FASCICULE DE BREVET EUROPEEN**

(45) Date de publication et mention de la délivrance du brevet:
**30.11.2022 Bulletin 2022/48**

(21) Numéro de dépôt: **16701002.4**

(22) Date de dépôt: **19.01.2016**

(51) Classification Internationale des Brevets (IPC):
**H03G 7/00** (2006.01)    **H04R 3/00** (2006.01)

(52) Classification Coopérative des Brevets (CPC):
**H04R 3/007; H03G 7/007**

(86) Numéro de dépôt international:
**PCT/EP2016/050995**

(87) Numéro de publication internationale:
**WO 2016/116435 (28.07.2016 Gazette 2016/30)**

(54) **DISPOSITIF DE COMMANDE D'UN HAUT-PARLEUR AVEC LIMITATION DE COURANT**

VORRICHTUNG ZUR STEUERUNG EINES LAUTSPRECHERS MIT STROMBEGRENZUNG

DEVICE FOR CONTROLLING A LOUDSPEAKER WITH CURRENT LIMITATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.01.2015 FR 1550413**

(43) Date de publication de la demande:
**29.11.2017 Bulletin 2017/48**

(73) Titulaire: **Devialet**
**75001 Paris (FR)**

(72) Inventeurs:
• **MENDES, Eduardo**
**26120 Chabeuil (FR)**
• **LEPOUTRE, Frédéric**
**75011 Paris (FR)**
• **CALMEL, Pierre-Emmanuel**
**78150 Le Chesnay (FR)**

(74) Mandataire: **Lavoix**
**2, place d'Estienne d'Orves**
**75441 Paris Cedex 09 (FR)**

(56) Documents cités:
**EP-A1- 2 469 708        JP-A- 2009 253 955**
**US-A1- 2009 268 918    US-A1- 2012 237 045**

**Description**

La présente invention concerne un dispositif de commande d'un haut-parleur dans une enceinte comportant :

- une entrée pour un signal audio à reproduire ;
- une sortie de fourniture d'un signal d'excitation du haut-parleur ;
- des moyens pour calculer, à chaque instant, au moins un courant prédit pour le signal d'excitation du haut-parleur en fonction du signal audio.

Le plus souvent les haut-parleurs sont alimentés en tension depuis l'amplificateur. A partir du signal sonore à diffuser, un amplificateur de tension applique une tension au haut-parleur proportionnelle au signal sonore à reproduire.

Le gain de proportionnalité est donné par le gain de volume désiré par l'utilisateur et le gain en tension de l'amplificateur.

Le courant circulant dans le haut-parleur, délivré par l'amplificateur, dépend de l'impédance du haut-parleur. La limitation en amplitude instantanée de ce courant peut se révéler nécessaire pour protéger l'amplificateur et/ou le haut-parleur. Cette limitation doit être réalisée sans introduction d'artefacts audibles du signal sonore diffusé par le haut-parleur.

Les méthodes proposées dans l'état de la technique sont le plus souvent basées sur une combinaison de circuits électroniques actifs et/ou passifs. Les circuits passifs ne sont pas ajustables, ne permettent pas un réglage fin du dispositif et sont sujets à des variations en cours de fonctionnement. Le principe de fonctionnement de ces circuits actifs et/ou passifs consiste, le plus souvent, à introduire un élément résistif en série avec le haut-parleur afin de réduire le courant, introduisant ainsi des pertes supplémentaires dans le système. Ce type de méthode nécessite la mise en place d'éléments électroniques supplémentaires dans l'installation, la rendant ainsi plus coûteuse, plus volumineuse et susceptible de pannes.

Des méthodes se basent sur un modèle du haut-parleur pour, à partir de la tension appliquée au haut-parleur, estimer le courant du haut-parleur, puis par la comparaison de ce courant avec un seuil prédéfini, réduire la tension appliquée au haut-parleur si le courant dépasse ce seuil. Cette méthode souffre de deux difficultés. Tout d'abord, le haut-parleur est un système dynamique électromécanique complexe et le seuil est complexe à définir. Ensuite, sous certaines conditions, diminuer la tension appliquée au haut-parleur aura pour effet d'augmenter le courant instantané et non de le réduire.

Des dispositifs de limitation de la tension appliquée au haut-parleur ou du déplacement de la membrane du haut-parleur sont largement décrits dans la littérature. Il s'agit de dispositifs appelés compresseurs (atténuateurs), pour la limitation directe en amplitude, ou de dispositifs utilisant des filtres à fréquence variable pilotée par la grandeur à limiter, pour la limitation indirecte en amplitude.

La limitation du courant impose donc soit un capteur de courant, soit des moyens d'estimation du courant à partir de la tension et des dispositifs de limitation de la tension appliquée au haut-parleur. Ces dispositifs sont relativement complexes et nuisent à la qualité de la restitution sonore, en corrigeant la tension appliquée au haut-parleur.

Par exemple, US2012/0237045, EP 2.469 708 et JP 2009 253955 décrivent des dispositifs de l'état de la technique.

L'invention a pour but de proposer une commande satisfaisante d'un haut-parleur, limitant le courant appliqué au haut-parleur qui soit simple à mettre en œuvre.

A cet effet, l'invention a pour objet un dispositif de commande d'un haut-parleur selon la revendication 1.

Suivant des modes particuliers de réalisation, le dispositif de commande est selon l'une quelconque des revendications 2 à 5.

L'invention sera mieux comprise à la lecture de la description qui va suivre, donnée uniquement à titre d'exemple et faite en se référant aux dessins sur lesquels :

- la figure 1 est une vue schématique d'une installation de restitution sonore ;
- la figure 2 est une courbe illustrant un modèle désiré de restitution sonore pour l'installation ;
- la figure 3 est une vue schématique de l'unité de commande du haut-parleur ;
- la figure 4 est une vue schématique détaillée de l'unité d'adaptation structurelle ;
- la figure 5 est une vue schématique détaillée de l'unité de calcul des grandeurs dynamiques de référence ;
- la figure 6 est une vue d'un circuit représentant la modélisation mécanique du haut-parleur en vue de sa commande dans une enceinte munie d'un évent ;
- la figure 7 est une vue d'un circuit représentant la modélisation électrique du haut-parleur en vue de sa commande ;
- la figure 8 est un organigramme de l'algorithme de limitation du courant circulant dans la bobine du haut-parleur ;
- la figure 9 est une vue schématique d'un premier mode de réalisation de l'unité d'estimation en boucle ouverte de la résistance du haut-parleur ;

- la figure 10 est une vue d'un circuit du modèle thermique du haut-parleur ;
- la figure 11 est une vue identique à celle de la figure 9 d'une variante de réalisation de l'unité d'estimation en boucle fermée de la résistance du haut-parleur ; et
- la figure 12 est une vue identique à celle de la figure 6 d'un autre mode de réalisation pour une enceinte munie d'un radiateur passif.

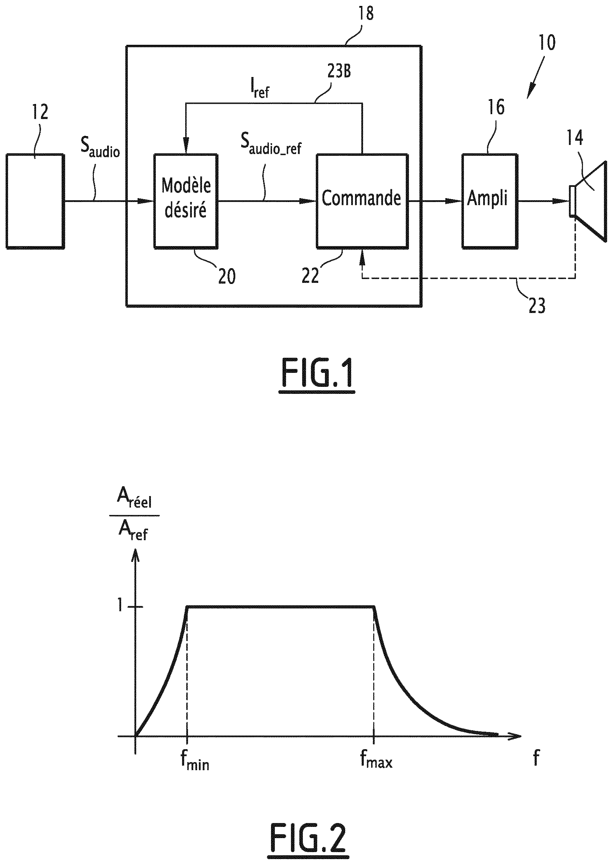

L'installation de restitution sonore 10 illustrée sur la figure 1 comporte, comme connu en soi, un module 12 de production d'un signal audio, tel qu'un lecteur de disque numérique relié à un haut-parleur 14 d'une enceinte au travers d'un amplificateur en tension 16. Entre la source audio 12 et l'amplificateur 16 est disposé une unité de commande 18 comprenant, successivement en série, un modèle désiré 20, correspondant au modèle désiré de comportement de l'enceinte, et un dispositif de commande 22. Ce modèle désiré est linéaire ou non linéaire.

Suivant un mode particulier de réalisation, une boucle 23 de mesure d'une grandeur physique, telle que la température du circuit magnétique du haut-parleur ou l'intensité circulant dans la bobine du haut-parleur est prévue entre le haut-parleur 14 et le dispositif de commande 22.

Le modèle désiré 20 est indépendant du haut-parleur utilisé dans l'installation et de sa modélisation.

Le modèle désiré 20 est, comme illustré sur la figure 2, une fonction exprimée en fonction de la fréquence du rapport de l'amplitude du signal souhaité notée $S_{audio\_ref}$ sur l'amplitude $S_{audio}$ du signal d'entrée issu du module 12.

Avantageusement, pour des fréquences inférieures à une fréquence de coupure $f_{min}$, ce rapport est une fonction convergeant vers zéro lorsque la fréquence tend vers zéro, pour limiter la reproduction des fréquences excessivement basses et ainsi éviter des déplacements de la membrane du haut-parleur hors des plages préconisées par le fabricant.

Il en est de même pour les fréquences élevées où le rapport tend vers zéro au-delà d'une fréquence $f_{max}$ lorsque la fréquence du signal tend vers l'infini.

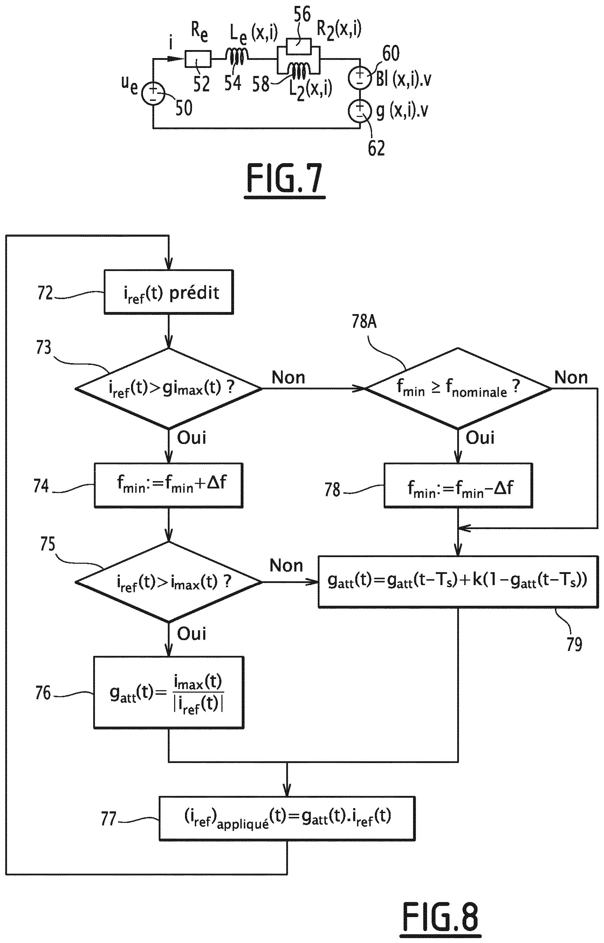

Le modèle désiré est propre à modifier en continu, c'est-à-dire à chaque pas de calcul du dispositif de commande, la fréquence de coupure minimale $f_{min}$, en fonction d'une intensité prédite $i_{ref}$ fournie par le dispositif de commande 22 au travers d'une liaison 23B comme cela sera décrit ultérieurement, notamment en regard de la fig. 8.

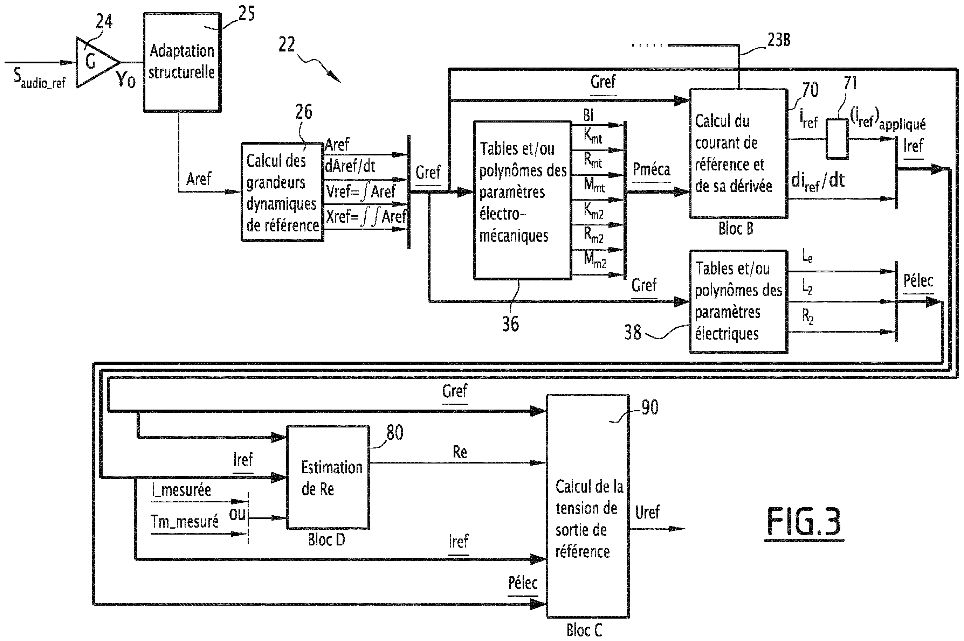

Le dispositif de commande 22, dont la structure détaillée est illustrée sur la figure 3, est disposé en entrée de l'amplificateur 16. Ce dispositif est propre à recevoir en entrée le signal audio $S_{audio\_ref}$ à reproduire tel que défini en sortie du modèle désiré 20 et à fournir en sortie un signal $U_{ref}$, formant un signal d'excitation du haut-parleur qui est fournie pour amplification à l'amplificateur 16. Ce signal $U_{ref}$ est adapté pour tenir compte de la non-linéarité du haut-parleur 14.

Le dispositif de commande 22 comporte des moyens de calcul de différentes quantités en fonction des valeurs de dérivées ou d'intégrales d'autres quantités définies aux mêmes instants.

Pour les nécessités de calcul, les valeurs des quantités non connues à l'instant n sont prises égales aux valeurs correspondantes de l'instant *n-1*. Les valeurs de l'instant *n-1* sont de préférence corrigées par une prédiction à l'ordre 1 ou 2 de leurs valeurs à l'aide des dérivées d'ordres supérieurs connues à l'instant *n-1*.

Selon l'invention, le dispositif de commande 22 met en œuvre une commande utilisant pour partie le principe de la platitude différentielle qui permet de définir un signal de commande de référence d'un système différentiellement plat à partir de trajectoires de référence suffisamment lisses.

Comme illustré sur la figure 3, le module de commande 22 reçoit en entrée le signal audio $S_{audio\_ref}$ à reproduire issu du modèle désiré 20. Une unité 24 d'application d'un gain de conversion d'unité, dépendant de la tension crête de l'amplificateur 16 et d'une atténuation variable entre 0 et 1 contrôlée par l'utilisateur, assure le passage du signal audio de référence $S_{audio\_ref}$ à un signal $\gamma_0$, image d'une grandeur physique à reproduire. Le signal $\gamma_0$ est, par exemple, une accélération de l'air en regard du haut-parleur ou encore une vitesse de l'air à déplacer par le haut-parleur 14. Dans la suite, on suppose que le signal $\gamma_0$ est l'accélération de l'air mis en mouvement par l'enceinte.

En sortie de l'unité d'amplification 24, le dispositif de commande comporte une unité 25 d'adaptation structurelle du signal à reproduire en fonction de la structure de l'enceinte dans laquelle est utilisé le haut-parleur. Cette unité est propre à fournir une grandeur de référence $A_{ref}$ souhaitée à chaque instant pour la membrane du haut-parleur à partir d'une grandeur correspondante, ici le signal $\gamma_0$, pour le déplacement de l'air mis en mouvement par l'enceinte comportant le haut-parleur.

Ainsi, dans l'exemple considéré, la grandeur de référence $A_{ref}$, calculée à partir de l'accélération de l'air à reproduire $\gamma_0$, est l'accélération à reproduire pour la membrane du haut-parleur afin que le fonctionnement du haut-parleur impose à l'air une accélération $\gamma_0$.

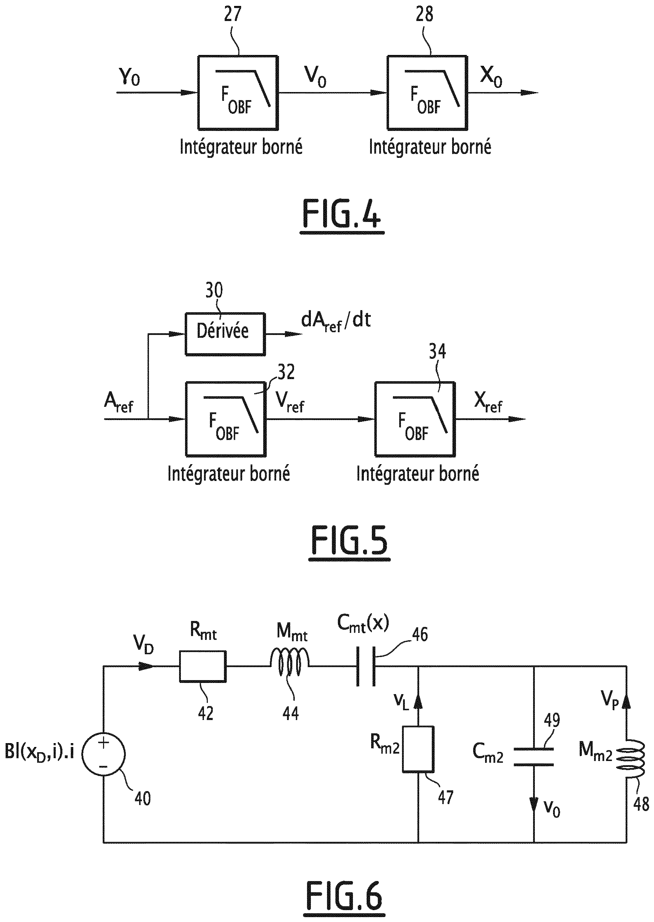

Sur la figure 4 est illustré un détail de l'unité d'adaptation structurelle 25. L'entrée $\gamma_0$ est reliée à une unité d'intégration bornée 27 dont la sortie est elle-même reliée à une autre unité d'intégration borné 28.

Ainsi, en sortie des unités 27 et 28 sont obtenues respectivement l'intégrale première $v_0$ et l'intégrale seconde $x_0$ de l'accélération $\gamma_0$.

Les unités d'intégration bornées sont formées d'un filtre passe-bas du premier ordre et sont caractérisées par une fréquence de coupure $F_{OBF}$.

L'utilisation d'unité d'intégration bornée permet que les grandeurs utilisées dans le dispositif de commande 22 ne soient les dérivées ou les intégrales les unes des autres que dans la bande passante utile, c'est-à-dire pour les fréquences supérieures à la fréquence de coupure $F_{OBF}$. Ceci permet de contrôler l'excursion en basse fréquence des grandeurs considérées.

En fonctionnement normal, la fréquence de coupure $F_{OBF}$ est choisie de manière à ne pas influencer le signal dans les basses fréquences de la bande passante utile.

La fréquence de coupure $F_{OBF}$ est prise inférieure au dixième de la fréquence $f_{min}$ du modèle désiré 20.

Dans le cas d'une enceinte à évent dans laquelle le haut-parleur est monté dans un boitier ouvert par un évent, l'unité 25 produit l'accélération de référence désirée pour la membrane $A_{ref}$ par la relation suivante :

$$A_{ref} = \gamma_D = \gamma_0 + \frac{K_{m2}}{R_{m2}}\, v_0 + \frac{K_{m2}}{M_{m2}}\, x_0$$

Avec :

$R_{m2}$ : coefficient de fuites acoustiques de l'enceinte ;
$M_{m2}$ : inductance à la masse d'air dans l'évent ;
$K_{m2}$ : raideur de l'air dans l'enceinte.

$x_0$ : position de l'air total déplacé par la membrane et l'évent $v_0 = \frac{dx_0}{dt}$ : vitesse de l'air total déplacé par la membrane et l'évent $\gamma_0 = \frac{dv_0}{dt}$ : accélération de l'air total déplacé.

Dans ce cas, l'accélération de référence désirée pour la membrane $A_{ref}$ est corrigée des grandeurs dynamiques structurelles $x_0$, $v_0$ de l'enceinte, ces dernières étant différentes des grandeurs dynamiques relatives à la membrane du haut-parleur.

Cette grandeur de référence $A_{ref}$ est introduite dans une unité de calcul 26 des grandeurs dynamiques de référence propre à fournir, à chaque instant, la valeur de la dérivée par rapport au temps de la grandeur de référence notée $dA_{ref}/dt$ ainsi que les valeurs des intégrales première et seconde par rapport au temps de cette grandeur de référence notée respectivement $V_{ref}$ et $X_{ref}$.

L'ensemble des grandeurs dynamiques de référence est noté dans la suite $G_{ref}$.

Sur la figure 5 est illustré un détail de l'unité de calcul 26. L'entrée $A_{ref}$ est reliée à une unité de dérivation 30 d'une part et à une unité d'intégration bornée 32 d'autre part dont la sortie est elle-même reliée à une autre unité d'intégration bornée 34.

Ainsi, en sortie des unités 30, 32 et 34 sont obtenues respectivement la dérivée de l'accélération $dA_{ref}/dt$, l'intégrale première $V_{ref}$ et l'intégrale seconde $X_{ref}$ de l'accélération.

Les unités d'intégration bornées sont formées d'un filtre passe-bas du premier ordre et sont caractérisées par une fréquence de coupure $F_{OBF}$.

L'utilisation d'unité d'intégration bornée permet que les grandeurs utilisées dans le dispositif de commande 22 ne soient les dérivées ou les intégrales les unes des autres que dans la bande passante utile, c'est-à-dire pour les fréquences supérieures à la fréquence de coupure $F_{OBF}$. Ceci permet de contrôler l'excursion en basse fréquence des grandeurs considérées.

En fonctionnement normal, la fréquence de coupure $F_{OBF}$ est choisie de manière à ne pas influencer le signal dans les basses fréquences de la bande passante utile.

La fréquence de coupure $F_{OBF}$ est prise inférieure au dixième de la fréquence $f_{min}$ du modèle désiré 20.

Le dispositif de commande 22 comporte, dans une mémoire, une table et/ou un ensemble de polynômes de paramètres électromécaniques 36 ainsi qu'une table et/ou un ensemble de polynômes des paramètres électriques 38.

Ces tables 36 et 38 sont propres à définir, en fonction des grandeurs dynamiques de référence $G_{ref}$ reçues en entrée, les paramètres électromécaniques $P_{méca}$ et électriques $P_{élec}$ respectivement. Ces paramètres $P_{méca}$ et $P_{élec}$ sont obtenus respectivement à partir d'une modélisation mécanique du haut-parleur telle qu'illustrée sur la figure 6, où le haut-parleur est supposé installé dans une enceinte à évent, et d'une modélisation électrique du haut-parleur telle qu'illustrée sur la figure 7.

Les paramètres électromécaniques $P_{méca}$ incluent le flux magnétique capté par la bobine noté Bl produit par le circuit magnétique du HP, la raideur du haut-parleur notée $K_{mt}(x_D)$, les frottements mécaniques visqueux du haut-parleur notés $R_{mt}$, la masse mobile de l'ensemble du haut-parleur notée $M_{mt}$, la raideur de l'air dans l'enceinte notée $K_{m2}$, les fuites acoustiques de l'enceinte notées $R_{m2}$ et la masse d'air dans l'évent notées $M_{m2}$.

La modélisation de la partie mécanico-acoustique du haut-parleur placé dans une enceinte à évent illustrée sur la figure 6 comprend, dans un circuit en boucle fermée unique, un générateur 40 de tension $Bl(x_D, i).i$ correspondant à la force motrice produite par le courant $i$ circulant dans la bobine du haut-parleur. Le flux magnétique $Bl(x_D, i)$ dépend de la position $x_D$ de la membrane ainsi que de l'intensité $i$ circulant dans la bobine.

Cette modélisation prend en compte le frottement mécanique visqueux $R_{mt}$ de la membrane correspondant à une résistance 42 en série avec une bobine 44 correspondant à la masse mobile d'ensemble $M_{mt}$ de la membrane, la raideur de la membrane correspondant à un condensateur 46 de capacité $C_{mt}(x_D)$ égale $1/K_{mt}(x_D)$. Ainsi, la raideur dépend de la position $x_D$ de la membrane.

Pour tenir compte de l'évent, les paramètres $R_{m2}$, $C_{m2}$ et $M_{m2}$ suivant sont utilisés :

$R_{m2}$ : coefficient de fuites acoustiques de l'enceinte ;
$M_{m2}$ : inductance équivalente à la masse d'air dans l'évent ;

$$C_{m2} = \frac{1}{K_{m2}}$$ : compliance de l'air dans l'enceinte.

Dans la modélisation de la figure 6, ils correspondent respectivement à une résistance 47, une bobine 48 et un condensateur 49 montés en parallèle.

Dans cette modélisation, la force issue de la réluctance du circuit magnétique est négligée.

Les variables utilisées sont :

$$v_D = \frac{dx_D}{dt}$$ : vitesse de la membrane du haut-parleur

$$\gamma_D = \frac{dv_D}{dt}$$ : accélération de la membrane du haut-parleur

$v_L$ : vitesse de l'air des fuites d'air

$v_p$ : vitesse de l'air en sortie de l'évent (port)

$$v_0 = \frac{dx_0}{dt} = v_D + v_L + v_P$$ : vitesse de l'air total déplacé par la membrane et l'évent $\quad \gamma_0 = \frac{dv_0}{dt}$ : accélération de l'air total déplacé.

La pression acoustique totale à 1 mètre est donnée par : $$p = \frac{\rho.S_D}{n_{str}\pi.}\gamma_0$$

où $S_D$ : section efficace du haut-parleur, $n_{str} = 2$ : angle solide d'émission.

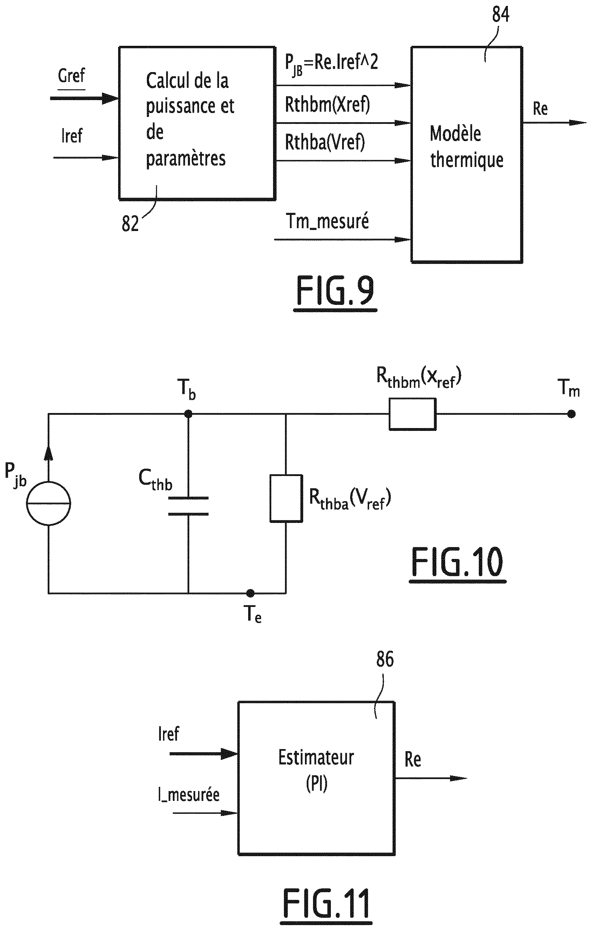

L'équation mécanico-acoustique correspondant à la figure 10 est la suivante :

$$Bl(x_D, i)i = M_{mt}\frac{dv_D}{dt} + R_{mt}v_D + K_{mt}(x_D)x_D + K_{m2}x_0$$

$$\gamma_0 = \gamma_D - \frac{K_{m2}}{R_{m2}}v_0 - \frac{K_{m2}}{M_{m2}}x_0$$

La relation suivante lie les différentes grandeurs :

La modélisation de la partie électrique du haut-parleur est illustrée par la figure 7.

Les paramètres électriques $P_{élec}$ incluent l'inductance de la bobine $L_e$, la para-inductance $L_2$ de la bobine et l'équivalent perte-fer $R_2$.

La modélisation de la partie électrique du haut-parleur illustrée sur la figure 7 est formée d'un circuit en boucle fermée. Il comporte un générateur 50 de force électromotrice $u_e$ relié en série à une résistance 52 représentative de la résistance $R_e$ de la bobine du haut-parleur. Cette résistance 52 est reliée en série avec une inductance $L_e(x_D, i)$ représentative de l'inductance de la bobine du haut-parleur. Cette inductance dépend de l'intensité $i$ circulant dans la bobine et de la position $x_D$ de la membrane.

Pour tenir compte des pertes magnétiques et des variations d'inductance par effet des courants de Foucault, un circuit parallèle RL est monté en série en sortie de la bobine 54. Une résistance 56 de valeur $R_2(x_D, i)$ dépendant de la position de la membrane $x_D$ et de l'intensité $i$ circulant dans la bobine est représentative de l'équivalent perte-fer. De même, une bobine 58 d'inductance $L_2(x_D, i)$ dépendant également de la position $x_D$ de la membrane et l'intensité $i$ circulant dans le circuit est représentative de la para-inductance du haut-parleur.

Sont également montés en série dans la modélisation, un générateur de tension 60 produisant une tension $Bl(x_D, i).v$ représentative de la force contre-électromotrice de la bobine en mouvement dans le champ magnétique produit par l'aimant et un seconde générateur 62 produisant une tension g($x_D$,i).v avec $g(x_D,i) = i\frac{dL_e(x_D,i)}{dx_D}$ représentative de l'effet de la variation dynamique de l'inductance avec la position.

De manière générale, on remarque que, dans cette modélisation, le flux BI capté par la bobine, la raideur $K_{mt}$ et l'inductance de la bobine $L_e$ dépendent de la position $x_D$ de la membrane, l'inductance $L_e$ et le flux BI dépendent également du courant i circulant dans la bobine.

De préférence, l'inductance de la bobine $L_e$, l'inductance $L_2$ et le terme g dépendent de l'intensité i, en plus de dépendre du déplacement $x_D$ de la membrane.

A partir des modélisations explicitées en regard des figures 6 et 7, les équations suivantes sont définies :

$$u_e = R_e i + L_e(x_D,i)\frac{di}{dt} + R_2(i - i_2) + Bl(x_D,i)v_D + \underbrace{i\frac{dL_e(x_D,i)}{dx_D}}_{g(x_D,i)}v_D$$

$$L_2\frac{di_2}{dt} = R_2 \ (i - i_2)$$

$$Bl(x_D,i)i = R_{mt}v_D + M_{mt}\frac{dv_D}{dt} + K_{mt}(x_D)x_D + K_{m2}x_0$$

Le module de commande 22 comporte en outre une unité 70 de calcul du courant de référence $i_{ref}$ et de sa dérivée $di_{ref}/dt$. Cette unité reçoit en entrée les grandeurs dynamiques de référence $G_{ref}$, les paramètres mécaniques $P_{méca}$, et les grandeurs $x_0$ et $v_0$. Ce calcul du courant de référence $I_{ref}$ et de sa dérivée $dI_{ref}/dt$ satisfont les deux équations :

$$G_1(x_{ref},i_{ref})i_{ref} = R_{mt}v_{ref} + M_{mt}A_{ref} + K_{mt}(x_{ref})x_{ref} + K_{m2}x_0$$

$$\frac{d}{dt}\left(G_1(x_{ref},i_{ref})i_{ref}\right) = R_{mt}A_{ref} + M_{mt}dA_{ref}/dt + K_{mt}(x_{ref})v_{ref} + K_{m2}v_0$$

avec

$$G_1(x_{ref},i_{ref}) = Bl(x_{ref},i_{ref}) - \frac{1}{2}i_{ref}\frac{dL_e(x_{ref},i_{ref})}{dx}.$$

Ainsi, le courant $i_{ref}$ et sa dérivée $di_{ref}/dt$ sont obtenus par un calcul algébrique à partir des valeurs des vecteurs entrés par un calcul analytique exacte ou une résolution numérique si nécessaire en fonction de la complexité de $G_1(x,i)$.

La dérivée du courant $di_{ref}/dt$ est ainsi obtenue de préférence par un calcul algébrique ou sinon par dérivation numérique.

Afin d'éviter une détérioration du haut-parleur 14, par circulation d'un courant trop important, l'unité de commande 18 comporte, d'une part, des moyens de modification de la fonction du modèle désiré 20 en fonction du courant $i_{ref}$(t) prédit par le dispositif de commande 22 transmis au travers de la connexion 23B et, d'autre part, une unité 71 de compression du courant $i_{ref}$ adapté pour maintenir le courant $i_{ref}$(t) en sortie de l'unité 71 à une valeur $(i_{ref})_{appliqué}$(t) inférieure à une valeur limite maximale $i_{max}$(t).

Les moyens de modification de la fonction du modèle désiré et l'unité 71 de compression sont mises en œuvre en combinaison ou seul l'un d'eux est mis en œuvre.

L'unité de compression 71 forme un atténuateur par application d'un gain d'atténuation $g_{att}$(t). Elle est prévue en sortie de l'unité 70 de calcul du courant comme illustré sur la figure 3.

Pour la limitation du courant $i_{ref}$(t) et donc le calcul du courant $(i_{ref})_{appliqué}$(t), l'algorithme de la figure 8 est mis en œuvre par l'unité de commande 18.

Lors d'une étape 72, le courant $i_{ref}$(t) prédit par l'unité de calcul de courant de référence 70 est fourni au modèle désiré 20 et à l'unité de compression 71. Ce courant dépend du temps comme expliqué précédemment. Il est fourni pour chaque pas de calcul de l'unité 70.

A l'étape 73, le courant $i_{ref}(t)$ est comparé à une fraction $g.i_{max}(t)$ du courant maximal admissible $i_{max}(t)$ par le haut-parleur. Le coefficient g est une valeur comprise entre 0 et 1 fixée lors de la conception de l'unité 18.

Si le courant de référence $i_{ref}(t)$ est supérieur à $g.i_{max}(t)$ alors, le modèle désiré 20 est modifié, notamment en augmentant progressivement la fréquence de coupure minimale $f_{min}$ du modèle désiré illustré sur la figure 2. Le modèle désiré est modifié à l'étape 74 progressivement avec une vitesse relativement lente propre à rendre inaudible les changements de fréquence de coupure.

Ainsi, dans l'exemple considéré, la fréquence minimale $f_{min}$ est augmentée d'une valeur Δf à chaque pas de calcul d'une nouvelle valeur $i_{ref}(t)$ par l'unité de commande 22.

En variante, le modèle désiré 20 comporte un filtre centré sur une fréquence prédéterminée (connu sou le nom de peak-notch en langue anglaise) propre à diminuer le courant dans une bande de fréquence désirée autour de la fréquence prédéterminée.

Dans ce cas, le gain du filtre est ajusté dans la bande de fréquence désirée en fonction du courant de référence $i_{ref}(t)$. A l'étape 74, le gain du filtre est diminué par incrément à une vitesse déterminée de manière à rendre inaudible les variations de gain du filtre.

Selon l'invention, une variation de la fréquence de coupure minimale $f_{min}$ et une variation du gain du filtre sont mises en œuvre simultanément ou indépendamment l'une de l'autre suivant le mode de réalisation mis en œuvre.

A l'étape 75, la valeur du courant de référence $i_{ref}(t)$ est comparée à la valeur de courant maximal $i_{max}(t)$.

Si $i_{ref}(t)$ est supérieur à $i_{max}(t)$, un gain d'atténuation $g_{att}(t)$ est calculé à l'étape 76. Le gain d'atténuation $g_{att}(t)$ est donné par la formule

$$g_{att}(t) = i_{max}(t) \, / \, \left| \, i_{ref}(t) \right|$$

A l'étape 77 suivante, la valeur de courant de référence limitée $(i_{ref})_{appliqué}(t)$ est calculée comme le produit du gain d'atténuation $g_{att}(t)$ précédemment calculé par le courant de référence $i_{ref}(t)$ par la formule

$$(i_{ref})_{appliqué}(t) = g_{att}(t) \times i_{ref}(t)$$

La valeur de courant de référence $(i_{ref})_{appliqué}(t)$ est utilisée par la suite pour le calcul de la tension de sortie de référence $U_{ref}$ qui sera amplifiée et appliquée aux bornes du haut-parleur 14.

A l'issue de l'étape 77, l'étape 72 est à nouveau mise en œuvre avec le nouveau courant de référence $i_{ref}(t)$ prédit lors du pas suivant par le dispositif de commande 22.

A l'étape 73, si la valeur du courant de référence $i_{ref}(t)$ est inférieure à $gi_{max}(t)$, alors l'étape 78 visant à diminuer la fréquence de coupure du modèle désiré est mise en œuvre, si lors du test effectué à l'étape 78A, la fréquence de coupure courante $f_{min}$ est supérieure à une fréquence nominale $f_{nominale}$. L'étape 78, opposée à l'étape 74 d'augmentation de la fréquence de coupure minimale, retranche à la fréquence de coupure courante $f_{min}$ l'incrément Δf propre à assurer une redescente progressive de la fréquence de coupure, tant que le courant de référence reste inférieur à la fraction du courant maximal $gi_{max}(t)$ et que la fréquence de coupure $f_{min}$ n'a pas atteint sa valeur nominale $f_{nominale}$.

Dans un mode de réalisation où le gain d'un filtre est modifié à l'étape 74, le gain du filtre est augmenté d'un pas lors de l'étape 78.

A l'issue de l'étape 78 ou si le test de l'étape 78A est négatif, un nouveau gain d'atténuation $g_{att}(t)$ est calculé à l'étape 79 à partir du gain d'atténuation antérieur $g_{att}(t-Ts)$ calculé lors du pas précédent afin de permettre une remontée progressive du gain à une vitesse dépendant d'un paramètre k. Le gain $g_{att}(t)$ est calculé suivant la formule :

$$g_{att}(t) = g_{att}(t\text{-}T_s) + k \times (1 - g_{att}(t\text{-}T_s))$$

où $g_{att}(t-Ts)$ est la valeur du gain d'atténuation au pas de calcul précédent, Ts étant le temps séparant deux calculs successifs

k est une constante comprise dans ]0,1[

$i_{max}(t)$ est la valeur plafond pour le courant

$i_{ref}(t)$ est la valeur prédite pour le courant.

Cette même étape 79 est mise en œuvre si, à l'issue du test de l'étape 75, le courant de référence $i_{ref}(t)$ est inférieur au courant $i_{max}(t)$.

Après calcul du nouveau gain d'atténuation $g_{att}(t)$, un nouveau calcul du courant de référence appliquée $i_{ref}(t)$ est conduit à l'étape 77 à partir du nouveau gain d'atténuation.

On conçoit que le calcul prédictif du courant de référence $i_{ref}(t)$ permet la prise en compte de ce courant de référence pour la modification du modèle désiré, et pour le calcul d'une valeur d'un courant de référence limite appliqué $(i_{ref})_{appliqué}(t)$ limité afin d'éviter la circulation d'un courant trop important dans le haut-parleur 14.

La présence de l'unité de compression 71 appliquée au courant de référence $i_{ref}$ évite la mise en œuvre d'un capteur de courant ainsi que la mise en œuvre d'éléments propres à réduire la tension du haut-parleur 14 par une résistance additionnelle.

En outre, le dispositif de commande 22 comporte une unité 80 d'estimation de la résistance $R_e$ du haut-parleur. Cet unité 80 reçoit en entrée les grandeurs dynamiques de référence $G_{ref}$, l'intensité des courants de référence $(i_{ref})$ appliqué et sa dérivée $d(i_{ref})_{appliqué}/dt$ et, suivant le mode de réalisation envisagé, la température mesurée sur le circuit magnétique du haut-parleur notée $T_{m\_mesurée}$ ou l'intensité mesurée au travers de la bobine notée $I_{\_mesurée}$.

En l'absence de mesure du courant circulant, l'unité d'estimation 80 est de la forme illustrée sur la figure 9. Il comporte en entrée un module 82 de calcul de la puissance et de paramètres et modèle thermique 84.

Le modèle thermique 84 assure le calcul de la résistance $R_e$ à partir des paramètres calculés, de la puissance déterminée et de la température mesurée $T_{m\_mesurée}$.

La figure 10 donne le schéma général utilisé pour le modèle thermique.

Dans ce modèle, la température de référence est la température de l'air interne de l'enceinte $T_e$.

Les températures considérées sont :

$T_b$ [°C] : température du bobinage ;
$T_m$ [°C] : température du circuit magnétique ; et
$T_e$ [°C] : température interne de l'enceinte supposée constante ou, idéalement, mesurée.

La puissance thermique considérée est :

$P_{Jb}$ [W] : puissance thermique apportée au bobinage par effet Joule ;
Le modèle thermique comporte, comme illustré sur la figure 9, les paramètres suivants :
$C_{tbb}$ [J/K] : capacité thermique du bobinage ;
$R_{thbm}$ [K/W] : résistance thermique équivalente entre le bobinage et le circuit magnétique ; et
$R_{thba}$ [K/W] : résistance thermique équivalente entre le bobinage et la température interne de l'enceinte ;
Les résistances thermiques équivalentes tiennent compte de la dissipation de chaleur par conduction et convection.

La puissance thermique $P_{Jb}$ apportée par le courant circulant dans le bobinage est donnée par :

$$P_{Jb}(t) = R_e(T_b)i^2(t)$$

où $R_e(T_b)$ est la valeur de la résistance électrique à la température $T_b$ :

$$R_e(T_b) = R_e(20°C) \times \left(1 + 4.10^{-3}(T_b - 20°C)\right)$$

où $R_e(20°C)$ est la valeur de la résistance électrique à 20°C.

Le modèle thermique donné par la figure 9 est le suivant :

$$C_{thb}\frac{dT_b}{dt} = \frac{1}{R_{thbm}(X_{ref})}(T_m - T_b) + \frac{1}{R_{thba}(V_{ref})}(T_e - T_b) + P_{Jb}$$

Sa résolution permet d'obtenir la valeur de la résistance $R_e$ à chaque instant.

En variante, comme illustré sur la figure 11, lorsque le courant $i$ circulant dans la bobine est mesuré, l'estimation de la résistance $R_e$ est assurée par un estimateur en boucle fermée, par exemple de type proportionnel intégral. Ceci permet d'avoir un temps de convergence rapide grâce à l'utilisation d'un correcteur proportionnel intégral.

Enfin, le dispositif de commande 22 comporte une unité 90 de calcul de la tension de sortie de référence $U_{ref}$, à partir des grandeurs dynamiques de référence $G_{ref}$, du courant de référence appliqué $(i_{ref})_{appliqué}$ et de sa dérivée $d(i_{ref})_{appliqué}/dt$, des paramètres électriques $P_{élec}$ et de la résistance $R_e$ calculée par l'unité 80. Cette unité de calcul de la tension de sortie de référence met en œuvre les deux équations suivantes :

Pour des raisons de simplification $(i_{ref})_{appliqué}$ est noté $i_{ref}$ dans les expressions suivantes

$$u_2 + \frac{L_2(x_{ref}, i_{ref})}{R_2(x_{ref}, i_{ref})} \frac{du_2}{dt} = L_2(x_{ref}, i_{ref}) \frac{di_{ref}}{dt}$$

$$u_{ref} = R_e i_{ref} + L_e(x_{ref}, i_{ref}) \frac{di_{ref}}{dt} + u_2 + Bl(x_{ref}, i_{ref}) v_{ref} + \underbrace{i_{ref} \frac{dL_e(x_{ref}, i_{ref})}{dt}}_{g(x_{ref}, i_{ref})} v_{ref}$$

De manière non revendiqué, dans le cas où l'amplificateur 16 est un amplificateur en courant et non en tension comme décrit précédemment, les unités 38, 80 et 90 du dispositif de commande sont supprimées et l'intensité de sortie de référence $i_{ref}$ commandant l'amplificateur est prise en sortie de l'unité 70.

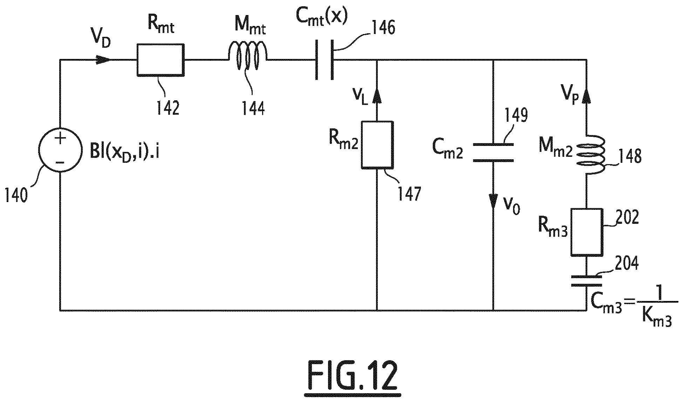

Dans le cas d'une enceinte comportant un radiateur passif formé d'une membrane, le modèle mécanique de la figure 6 est remplacé par celui de la figure 12 dans laquelle les éléments identiques à ceux de la figure 6 portent les mêmes numéros de référence. Ce module comporte en série avec la bobine $M_{m2}$ 48, correspondant à la masse de la membrane du radiateur passif, une résistance 202 et un condensateur 204 de valeur $C_{m3} = \frac{1}{K_{m3}}$ correspondant respectivement aux pertes mécaniques $R_{m2}$ du radiateur passif et à la raideur mécanique $K_{m3}$ de la membrane du radiateur passif. L'accélération de référence de la membrane $A_{ref}$ est donnée par :

$$A_{ref} = \gamma_0 + \frac{K_{m2}}{R_{m2}} v_0 + \frac{K_{m2}}{M_{m2}} x_{0R}$$

avec $x_{0R}$ donné par filtrage par un filtre passe-haut de $x_0$ :

$$x_{0R} = \frac{s^2}{s^2 + \frac{R_{m3}}{M_{m2}} s + \frac{K_{m3}}{M_{m2}}} x_0$$

Ainsi, la structure d'adaptation structurelle 25 comportera en série deux intégrateurs bornés pour l'obtention de $v_0$ et $x_0$ à partir de $\gamma_0$, puis le calcul de $x_{0R}$ à partir de $x_0$ par filtrage passe-haut avec les paramètres supplémentaires $R_{m3}$ et $K_{m3}$ qui sont respectivement, la résistance de pertes mécaniques et la constante de raideur mécanique de la membrane du radiateur passif.

**Revendications**

1. Dispositif de commande d'un haut-parleur (14) dans une enceinte, le dispositif de commande comportant :

    - une entrée pour un signal audio ($S_{audio}$) à reproduire ;
    - une sortie de fourniture d'un signal d'excitation du haut-parleur ;
    - des moyens (26, 36, 38, 70, 71, 80, 90) pour calculer, à chaque instant (t), au moins un courant prédit ($i_{ref}$(t)) pour le signal d'excitation du haut-parleur (14) en fonction du signal audio ($S_{audio}$) ;
    **caractérisé en ce que** le dispositif de commande comporte un atténuateur (71) propre à limiter le courant prédit ($I_{ref}$(t)) à une valeur de courant limité (($I_{ref})_{appliqué}$) inférieure à une valeur plafond ($I_{max}$ (t)) par application, au courant prédit ($i_{ref}$(t)) d'un gain d'atténuation ($g_{att}$(t)) qui est fonction du courant prédit ($i_{ref}$(t)),

    l'atténuateur (71) étant propre à appliquer un gain d'atténuation ($g_{att}$(t)) compris entre 0 et 1 et qui tend vers 1 lorsque la valeur du courant prédit est inférieure à la valeur plafond ($I_{max}$(t)),
    le gain d'atténuation ($g_{att}$(t)) satisfaisant les relations :

$$\text{Si } \left| i_{ref}(t) \right| > i_{max}(t) \text{ alors } g_{att}(t) = i_{max}(t) / \left| i_{ref}(t) \right|$$

$$\text{Si } \left| i_{ref}(t) \right| \leq i_{max}(t) \text{ alors } g_{att}(t) = g_{att}(t\text{-}T_s) + k \times (1 - g_{att}(t\text{-}T_s))$$

où $g_{att}$(t-Ts) est la valeur du gain d'atténuation au pas de calcul précédent, Ts étant le temps séparant deux calculs successifs
k est une constante comprise dans ]0,1[
$i_{max}$(t) est la valeur plafond pour le courant
$i_{ref}$(t) est la valeur prédite pour le courant,

le dispositif de commande comportant des moyens (80) de calcul d'une tension ($U_{ref}$) à appliquer à partir du courant (Iref(t)) à appliquer, la tension ($U_{ref}$) à appliquer dépendant de la valeur du courant limité (($I_{ref}$)$_{appliqué}$(t)),
la tension ($U_{ref}$) à appliquer formant le signal d'excitation dudit haut-parleur.

2. Dispositif selon la revendication 1, **caractérisé en ce qu'**il comporte, en amont des moyens (26, 36, 38, 70, 71, 80, 90) pour calculer le courant prédit ($i_{ref}$(t)), un modèle désiré (20) propre à appliquer une fonction de filtrage définissant le rapport de l'amplitude d'un signal souhaité ($S_{audio\_ref}$) sur l'amplitude ($S_{audio}$) du signal audio issu d'un module (12) de production d'un signal audio en fonction de la fréquence et **en ce que** le modèle désiré (20) est propre à modifier la fonction de filtrage en fonction du courant prédit ($i_{ref}$ (t)).

3. Dispositif selon la revendication 2, **caractérisé en ce que** la fonction de filtrage est telle que, pour des fréquences inférieures à une fréquence de coupure ($f_{min}$), le rapport des amplitudes est une fonction convergeant vers zéro lorsque la fréquence tend vers zéro et **en ce que** le modèle désiré (20) est propre à modifier la fréquence de coupure ($f_{min}$) en fonction du courant prédit ($i_{ref}$ (t)).

4. Dispositif selon la revendication 2 ou 3, **caractérisé en ce que** le modèle désiré (20) comporte un filtre centré sur une fréquence prédéterminée propre à diminuer le courant dans une bande de fréquence désirée autour de la fréquence prédéterminée.

5. Dispositif selon la revendication 4, **caractérisé en ce que** le modèle désiré (20) est propre à modifier le gain du filtre en fonction du courant prédit ($i_{ref}$(t)).

**Patentansprüche**

1. Steuervorrichtung eines Lautsprechers (14) in einem Gehäuse, die Steuervorrichtung umfassend:

- einen Eingang für ein Audiosignal ($S_{audio}$), das wiedergegeben werden soll;
- einen Ausgang zum Bereitstellen eines Erregungssignals des Lautsprechers;
- Einrichtungen (26, 36, 38, 70, 71, 80, 90), um zu jedem Zeitpunkt (t) mindestens einen vorhergesagten Strom ($i_{ref}$(t)) für das Erregungssignal des Lautsprechers (14) abhängig von dem Audiosignal ($S_{audio}$) zu berechnen;

**dadurch gekennzeichnet, dass** die Steuervorrichtung einen Dämpfer (71) umfasst, der geeignet ist, um den vorhergesagten Strom ($I_{ref}$(t)) auf einen Grenzstromwert (($I_{ref}$)$_{angelegt}$) zu begrenzen, der kleiner ist als ein Höchstwert ($I_{max}$ (t)), durch Anwenden einer Dämpfungsverstärkung ($g_{att}$(t)), die abhängig ist von dem vorhergesagten Strom ($i_{ref}$(t)), auf den vorhergesagten Strom ($i_{ref}$(t)),
wobei der Dämpfer (71) geeignet ist, um eine Dämpfungsverstärkung ($g_{att}$(t)) anzuwenden, die zwischen 0 und 1 liegt und die gegen 1 tendiert, wenn der Wert des vorhergesagten Stroms kleiner ist als der Höchstwert ($I_{max}$(t)) ist,
wobei die Dämpfungsverstärkung ($g_{att}$(t)) die folgenden Beziehungen erfüllt:

$$\text{Wenn } \left| i_{ref}(t) \right| > i_{max}(t) \text{ dann } g_{att}(t) = i_{max}(t) / \left| i_{ref}(t) \right|$$

$$\text{Wenn } | \, i_{ref}(t) \, | \leq i_{max}(t) \text{ dann } g_{att}(t) = g_{att}(t\text{-}T_s) + k \times (1 - g_{att}(t\text{-}T_s))$$

wobei $g_{att}(t\text{-}Ts)$ der Wert der Dämpfungsverstärkung in dem vorherigen Rechenschritt ist, wobei $T_s$ die Zeit zwischen zwei aufeinanderfolgenden Berechnungen ist

k eine Konstante in ]0,1[ ist

$i_{max}(t)$ der Höchstwert für den Strom ist

$i_{ref}(t)$ der vorhergesagte Wert für den Strom ist,

die Steuervorrichtung umfassend Einrichtungen (80) zum Berechnen einer anzulegenden Spannung ($U_{ref}$) anhand des anzulegenden Stroms ($I_{ref}(t)$), wobei die anzulegende Spannung ($U_{ref}$) von dem Wert des angelegten Grenzstroms (($I_{ref})_{angelegt}(t)$) abhängt,

die anzulegende Spannung ($U_{ref}$) das Erregungssignal des Lautsprechers bildet.

2. Vorrichtung nach Anspruch 1, **dadurch gekennzeichnet, dass** sie stromaufwärts von Einrichtungen (26, 36, 38, 70, 71, 80, 90) zum Berechnen des vorhergesagten Stroms ($i_{ref}(t)$) ein gewünschtes Modell (20) umfasst, das geeignet ist, eine Filterfunktion anzuwenden, die das Verhältnis der Amplitude eines gewünschten Signals ($S_{audio\_ref}$) zu der Amplitude ($S_{audio}$) des Audiosignals definiert, das von einem Modul (12) zum Erzeugen eines Audiosignals abhängig von der Frequenz ausgegeben wird, und, dass das gewünschte Modell (20) geeignet ist, um die Filterfunktion abhängig von dem vorhergesagten Strom ($I_{ref}(t)$) zu modifizieren.

3. Vorrichtung nach Anspruch 2, **dadurch gekennzeichnet, dass** die Filterfunktion derart ist, dass für Frequenzen unterhalb einer Grenzfrequenz ($f_{min}$) das Verhältnis der Amplituden eine Funktion ist, die gegen Null konvergiert, wenn die Frequenz gegen Null tendiert, und, dass das gewünschte Modell (20) geeignet ist, um die Grenzfrequenz ($f_{min}$) abhängig von dem vorhergesagten Strom ($i_{ref}(t)$) zu modifizieren.

4. Vorrichtung nach Anspruch 2 oder 3, **dadurch gekennzeichnet, dass** das gewünschte Modell (20) einen auf eine vorbestimmte Frequenz zentrierten Filter umfasst, der geeignet ist, den Strom in einem gewünschten Frequenzband um die vorbestimmte Frequenz zu verringern.

5. Vorrichtung nach Anspruch 4, **dadurch gekennzeichnet, dass** das gewünschte Modell (20) geeignet ist, um die Verstärkung des Filters abhängig von dem vorhergesagten Strom ($i_{ref}(t)$) zu modifizieren.

**Claims**

1. A control device for controlling a loudspeaker (14) in a loudspeaker enclosure, the control device comprising:

- an input for an audio signal ($S_{audio}$) to be reproduced;
- a supply output for supplying an excitation signal for the loudspeaker;
- the calculation means (26, 36, 38, 70, 71, 80, 90) for calculating, at each time instant (t), at least one predicted current ($i_{ref}(t)$) for the excitation signal for the loudspeaker (14) as a function of the audio signal ($S_{audio}$);

**characterised in that** the control device comprises an attenuator (71) that is capable of limiting the predicted current ($I_{ref}(t)$) to a limited current value (($i_{ref})_{applied}$) that is lower than a ceiling value ($I_{max}(t)$) by application, to the predicted current ($i_{ref}(t)$), of an attenuation gain ($g_{att}(t)$) which is a function of the predicted current ($i_{ref}(t)$),

the attenuator (71) being capable of applying an attenuation gain ($g_{att}(t)$) comprised between 0 and 1 and which tends to 1 when the value of the limited current is lower than the ceiling value ($I_{max}(t)$),

the attenuation gain ($g_{att}(t)$) satisfying the following relations:

$$\text{If } | \, i_{ref}(t) \, | > i_{max}(t) \text{ then } g_{att}(t) = i_{max}(t)/ \, | \, i_{ref}(t) \, |$$

$$\text{If } | \, i_{ref}(t) \, | \leq i_{max}(t) \text{ then } g_{att}(t) = g_{att}(t\text{-}T_s) + k \times (1 - g_{att}(t\text{-}T_s))$$

where $g_{att}(t - Ts)$ is the value of the attenuation gain at the preceding calculation step, Ts being the time separating two successive calculations;
k is a constant that is included in ]0,1[;
$i_{max}(t)$ is the ceiling value for the current;
$i_{ref}(t)$ is the predicted value for the current,

the control device including calculation means (80) for calculation of the voltage ($U_{ref}$) to be applied based on the current (Iref(t)) to be applied, the voltage ($U_{ref}$) to be applied depending on the value of the current limited (($I_{ref}$)$_{applied}$(t)), and
the voltage ($U_{ref}$) to be applied forming the excitation signal of the loudspeaker.

2. The device according to claim 1, **characterised in that** it includes, upstream of the calculation means (26, 36, 38, 70, 71, 80, 90) for calculating the predicted current ($i_{ref}(t)$), a desired model (20) that is capable of applying a filtering function defining the ratio of the amplitude of a desired signal ($S_{audio\_ref}$) over the amplitude ($S_{audio}$) of the signal originating from a production module (12) for producing an audio signal as a function of the frequency and **in that** the desired model (20) is capable of modifying the filtering function based on the predicted current ($i_{ref}(t)$).

3. The device according to claim 2, **characterised in that** the filtering function is such that, for the frequencies that are lower than a cut-off frequency ($f_{min}$), the ratio of the amplitudes is a function converging to zero when the frequency tends to zero and **in that** the desired model (20) is capable of modifying the cut-off frequency ($f_{min}$) as a function of the predicted current ($i_{ref}(t)$).

4. The device according to claim 2 or 3, **characterised in that** the desired model (20) includes a filtre centered on a predetermined frequency that is capable of decreasing the current in a desired frequency band around the predetermined frequency.

5. The device according to claim 4, **characterised in that** the desired model (20) is capable of modifying the gain of the filtre as a function of the predicted current ($i_{ref}(t)$).

$$\underline{\text{FIG.1}}$$

$$\underline{\text{FIG.2}}$$

FIG.3

FIG.4

FIG.5

FIG.6

## FIG.7

## FIG.8

FIG.9

FIG.10

FIG.11

$$\underline{FIG.12}$$

## RÉFÉRENCES CITÉES DANS LA DESCRIPTION

**Documents brevets cités dans la description**

- US 20120237045 A
- EP 2469708 A
- JP 2009253955 A